# FASCICULE DE BREVET EUROPEEN

(11) **EP 0 562 665 B1**
(45) Date de publication et mention de la délivrance du brevet: **01.10.1997**
(21) Numéro de dépôt: 93200741.2
(22) Date de dépôt: 15.03.1993
(51) Int. Cl.: C01D 7/35, C01D 7/42, B01D 9/00

(54) **Installation et procédé pour la cristallisation d'une substance minérale et procédé et installation pour la cristallisation de carbonate de sodium monohydraté**
Vorrichtung und Verfahren zur Kristallisation eines Minerals und Vorrichtung und Verfahren zur Kristallisation von Natriumcarbonatmonohydrat
Installation and process for the crystallisation of a mineral and installation and process for the crystallisation of sodium carbonate monohydrate

(30) Priorité: 25.03.1992 FR 9203698
(43) Date de publication de la demande: 29.09.1993
(73) Titulaire: SOLVAY (Société Anonyme), B-1050 Bruxelles (BE)
(72) Inventeur: Ninane, Léon, F-54110 Dombasle-sur-Meurthe (FR); Breton, Claude, F-54110 Dombasle-sur-Meurthe (FR)
(74) Mandataire: Anthoine, Paul

(56) Documents cités:
- EP-A- 0 073 085
- DE-A- 351 947
- US-A- 3 314 748
- D.W.GREEN ET AL. (ED.) 'Perry's Chemical Enginieers' Handbook 6th Edn.' 1985 , MCGRAW-HILL , NEW YORK, USA * page 19-13: Particle size reduction in dispersions *

## Description

L'invention a pour objet la cristallisation de substances minérales.

Elle concerne en particulier une installation conçue pour la cristallisation d'une substance minérale.

Des installations de cristallisation connues comprennent une chambre de cristallisation et un dispositif conçu pour provoquer dans la chambre, une circulation d'un brouet formé d'une dispersion de cristaux dans une solution saturée en la matière à cristalliser. Pendant l'exploitation de ces installations connues, le brouet est le siège d'une cristallisation par sursaturation-désursaturation de la solution, en étant par ailleurs soumis à une circulation permanente dans la chambre de cristallisation. Des installations de cristallisation de ce type trouvent une application pour la cristallisation de carbonate de sodium monohydraté au départ de carbonate de sodium anhydre [brevet BE-A-661071 (ALLIED CHEMICAL CORP.) et EP-B-073085 (SOLVAY)].

Une difficulté rencontrée dans l'exploitation de ces installations de cristallisation connues réside dans la difficulté de maîtriser la granulométrie des cristaux produits.

L'invention remédie à cette difficulté en fournissant une installation de cristallisation de conception nouvelle, qui permet de régler à volonté et de manière précise les caractéristiques granulométriques des cristaux produits.

En conséquence, l'invention concerne une installation pour la cristallisation d'une substance minérale dans un brouet de cristaux, par désursaturation d'une solution sursaturée, l'installation comprenant une chambre de cristallisation et un dispositif conçu pour réaliser une circulation du brouet dans la chambre de cristallisation; selon l'invention, la chambre de cristallisation contient un organe de cisaillement mécanique du brouet, comprenant un disque pourvu, à sa périphérie, d'une couronne de dents de cisaillement.

Dans l'installation selon l'invention, la chambre de cristallisation peut avoir toute forme appropriée. On utilise avantageusement une chambre de révolution, de préférence d'axe vertical, par exemple une chambre cylindrique, conique ou tronconique.

On entend désigner par brouet de cristaux une suspension de cristaux d'une matière minérale dans une solution aqueuse ou organique sursaturée en la substance à cristalliser. La matière minérale formant les cristaux du brouet peut indifféremment être identique à la substance minérale à cristalliser ou différente de celle-ci. Ladite matière est habituellement identique à la substance minérale à cristalliser.

Le dispositif pour réaliser la circulation du brouet dans la chambre de cristallisation n'est pas critique et peut par exemple comprendre une ou plusieurs hélices, une turbine ou un ou plusieurs éjecteurs de fluide. On préfère utiliser une hélice ou un ensemble d'hélices. Des exemples d'hélices utilisables dans l'installation selon l'invention sont notamment décrits dans Kirk-Othmer, Encyclopedia of Chemical Technology, 3rd Edition, Vol. 15, 1981, pages 607 à 611.

L'organe de cisaillement mécanique du brouet est un appareil destiné à soumettre le brouet à une contrainte de cisaillement forçant deux veines contiguës du brouet à se déplacer l'une par rapport à l'autre le long d'une surface commune. Selon l'invention, l'organe de cisaillement comprend un disque pourvu, à sa périphérie, d'une couronne de dents de cisaillement.

Dans l'installation selon l'invention, la couronne de dents du disque a pour fonction d'engendrer une contrainte de cisaillement dans le brouet sous l'action de la rotation du disque. Les dents peuvent avoir tout profil compatible avec la fonction de cisaillement. Elles sont de préférence profilées de manière à éviter qu'elles engendrent un déplacement d'ensemble radial ou axial (par rapport a l'axe du disque) du brouet. A cet effet, selon une forme de réalisation particulière, les dents de cisaillement sont disposées symétriquement de part et d'autre du disque et elles sont avantageusement dirigées perpendiculairement au plan du disque. Les dents peuvent par exemple avoir un profil similaire à celui des dents d'une scie et être obtenues par une découpe et un pliage appropriés de la zone périphérique du disque.

Toutes autres choses égales, la grandeur de la contrainte de cisaillement va dépendre des positions relatives du dispositif de circulation et du disque de cisaillement. On préfère, selon une forme de réalisation particulière de l'installation selon l'invention, disposer le disque dans la chambre de cristallisation de manière que, pendant le fonctionnement normal de l'installation, la vitesse de circulation du brouet de cristaux dans la chambre de cristallisation présente une composante tangentielle au disque. On préfère une position du disque, pour laquelle ladite composante tangentielle est au moins égale et de préférence supérieure à la composante de la vitesse, qui est normale au disque, une composante tangentielle au moins égale au double de la composante normale étant recommandée.

En variante, l'organe de cisaillement peut comprendre deux ou plusieurs disques de cisaillement tels que décrits plus haut, montés sur un même arbre de rotation ou sur des arbres de rotation différents.

Pendant le fonctionnement normal de l'installation selon l'invention, la chambre de réaction contient un brouet de cristaux tel que défini plus haut et l'ensemble du brouet est soumis à une circulation permanente dans la chambre, au contact du disque. Sous l'effet de la rotation du disque, la couronne de dents soumet le brouet à une contrainte locale de cisaillement dont l'intensité peut être réglée à volonté en modifiant la vitesse de rotation du disque. La contrainte de cisaillement a pour résultat de provoquer une désursaturation locale de la solution sursaturée, conduisant à la formation spontanée d'un grand nombre de germes de petites dimensions. L'importance du nombre de germes produits sous l'effet du cisaillement dépend de l'intensité de la contrainte de cisaillement et elle conditionne le diamètre moyen des cristaux produits dans la chambre de cristallisation. L'intensité de la contrainte de cisaillement sur le brouet va par ailleurs dépendre du débit de circulation du brouet dans la chambre de cristallisation, du nombre de dents de cisaillement du disque, de leur profil et de leurs dimensions, ainsi que de la vitesse de rotation du disque.

La contrainte de cisaillement peut en outre provoquer un bris des cristaux du brouet.

Dans une forme de réalisation préférée de l'installation selon l'invention, la chambre de cristallisation est délimitée par une enceinte cylindrique verticale et est divisée en une zone centrale et une zone annulaire par une cheminée cylindrique, disposée axialement dans l'enceinte et ouverte à ses extrémités supérieure et inférieure; dans cette forme de réalisation de l'installation, le dispositif de circulation est conçu de manière que ladite circulation du brouet dans la chambre de cristallisation comprenne une translation verticale dans la zone centrale et une translation verticale de sens opposé dans la zone annulaire. Dans cette forme de réalisation de l'installation, on préfère mettre en oeuvre une translation descendante du brouet dans la zone centrale et une translation ascendante dans la zone annulaire. Une installation de ce type est notamment décrite dans le brevet EP-B-073085 (SOLVAY). Dans une variante avantageuse de cette forme de réalisation de l'installation selon l'invention, le dispositif de circulation du brouet comprend une hélice à écoulement axial qui est disposée dans la zone centrale, de préférence dans la partie inférieure de celle-ci, et le disque de cisaillement est disposé au-dessous de la cheminée et a son axe de rotation disposé obliquement ou perpendiculairement par rapport à l'axe de rotation de l'hélice. Dans cette variante de l'invention, la partie inférieure de la zone centrale est la partie de cette zone qui s'étend sur la moitié inférieure de la hauteur de la cheminée, de préférence le tiers inférieur de celle-ci.

Dans la forme de réalisation qui vient d'être décrite de l'installation selon l'invention, des agglomérats de cristaux peuvent avoir tendance à se former de manière intempestive et anarchique et à sédimenter dans le fond de la chambre de cristallisation. Ces agglomérats peuvent être à l'origine de difficultés lors du soutirage du brouet.

A cet effet, dans un mode d'exécution particulier de la forme de réalisation qui vient d'être décrite, un dispositif de soutirage du brouet comprend un tuyau qui débouche dans une des zones précitées.

Dans ce mode d'exécution de l'invention, la disposition du tuyau dans la chambre de cristallisation n'est pas critique, pourvu qu'il débouche, à une extrémité, dans la zone centrale ou la zone annulaire, l'autre extrémité du tuyau étant en dehors de la chambre de cristallisation. L'endroit de la zone centrale ou de la zone annulaire où le tuyau débouche est de préférence situé dans la partie médiane de ladite zone. On entend désigner par partie médiane de la zone centrale ou de la zone annulaire, la partie de celle-ci, qui est située entre le tiers inférieur et le tiers supérieur de la hauteur de la cheminée. Il est avantageux de faire déboucher le tuyau dans la moitié supérieure de la zone.

Dans une variante préférée du mode d'exécution précité de l'installation selon l'invention, la zone où le tuyau débouche est la zone centrale. Dans cette variante de l'invention, il est avantageux de faire déboucher le tuyau au voisinage immédiat de la cheminée. A cet effet, le tuyau peut s'étendre dans la zone annulaire de la chambre de cristallisation et traverser la cheminée. Dans cette variante de l'invention, le tuyau occupe de préférence une position verticale dans la zone annulaire qu'il quitte en traversant l'enceinte dans le fond ou au voisinage du fond de la chambre de cristallisation.

L'installation selon l'invention convient pour tous les procédés de cristallisation dans lesquels une matière cristallise au sein d'un brouet de cristaux, par désursaturation d'une solution sursaturée en la substance à cristalliser.

L'invention concerne dès lors également un procédé pour la cristallisation d'une substance minérale, selon lequel on met en oeuvre un brouet de cristaux dans une solution sursaturée en la substance à cristalliser, on soumet le brouet à une circulation dans une installation de cristallisation conforme à l'invention, on cristallise la substance minérale par désursaturation de la solution et on soutire une fraction au moins du brouet hors de l'installation.

Dans le procédé selon l'invention, le mécanisme de la cristallisation est le résultat d'une désursaturation de la solution sursaturée. Celle-ci peut être obtenue par exemple par une réaction chimique, un refroidissement, un chauffage ou une évaporation.

Le procédé selon l'invention trouve une application intéressante pour la cristallisation de carbonate de sodium monohydraté à partir de carbonate de sodium anhydre.

Dans une forme de réalisation de cette application de l'invention, on met en oeuvre un brouet formé de cristaux de carbonate de sodium monohydraté dans une solution aqueuse saturée de carbonate de sodium monohydraté et on sursature la solution en carbonate de sodium monohydraté en y introduisant du carbonate de sodium anhydre.

Dans cette forme de réalisation du procédé selon l'invention, l'origine du carbonate de sodium anhydre n'est pas critique. On utilise avantageusement des cristaux de carbonate de sodium anhydre léger résultant de la calcination de bicarbonate de sodium obtenu par le procédé à l'ammoniaque.

Le brouet de cristaux de carbonate de sodium monohydraté peut être obtenu de diverses façons. Il peut par exemple provenir d'une source extérieure au procédé ou être obtenu par évaporation partielle d'une solution aqueuse de carbonate de sodium. En général, on règle avantageusement la concentration du brouet de carbonate de sodium monohydraté pour qu'il contienne entre 20 et 60 %, de préférence entre 30 et 55 % en poids de cristaux de carbonate de sodium monohydraté.

La température du brouet, pendant l'exécution du procédé, doit être maintenue au-dessous de la température de transition du carbonate de sodium monohydraté en carbonate de sodium anhydre. La température optimum dépend de divers facteurs, notamment de la concentration du brouet et de la granulométrie des cristaux de carbonate de sodium monohydraté qu'il contient, ainsi que de la granulométrie et de la morphologie du carbonate de sodium anhydre mis en oeuvre. Elle peut être déterminée dans chaque cas particulier par un travail de routine au laboratoire. En règle générale, on choisit une température telle que son écart par rapport à la température de transition précitée soit compris entre environ 2 et environ 25 °C, de préférence inférieur à 15 °C, les meilleurs résultats étant obtenus avec un écart compris entre 3 et 10 °C.

Le carbonate de sodium anhydre peut être à la température ambiante. On préfère toutefois, selon une forme d'exécution avantageuse du procédé selon l'invention, mettre en oeuvre du carbonate de sodium anhydre chaud, se trouvant de préférence à une température au moins égale à la température du brouet de cristaux.

Dans la chambre de cristallisation, le brouet de cristaux est soumis à une circulation interne, de manière à faciliter et accélérer l'incorporation du carbonate de sodium anhydre introduit dans ladite chambre.

Dans la forme de réalisation qui vient d'être décrite, du procédé selon l'invention, le carbonate de sodium anhydre se dissout dans la solution aqueuse du brouet, qu'il sursature ainsi en carbonate de sodium monohydraté, et du carbonate de sodium monohydraté cristallise par désursaturation de la solution.

Cette forme de réalisation du procédé selon l'invention peut avantageusement être exécutée dans une installation du type de celle décrite dans le brevet belge BE-A-661071. A cet effet, on met en oeuvre une chambre de cristallisation comprenant une paroi latérale, un fond et un couvercle, on fait circuler le brouet de cristaux de carbonate de sodium monohydraté dans la chambre de cristallisation et on introduit le carbonate de sodium anhydre à l'état d'une poudre dans la chambre de cristallisation, par l'intermédiaire d'un tube traversant le couvercle de la chambre de cristallisation. Dans ce mode d'exécution du procédé selon l'invention, la chambre de cristallisation peut avoir toute forme appropriée. On utilise avantageusement une chambre de révolution, de préférence d'axe vertical. Le cas échéant, la paroi latérale peut par exemple avoir un profil cylindrique ou tronconique, le fond, un profil conique, tronconique ou hémisphérique et le couvercle, un profit plan, conique, tronconique ou hémisphérique. Le tube servant à l'admission du carbonate de sodium anhydre traverse le couvercle, de préférence axialement.

Des particularités et détails de l'invention vont ressortir de la description suivante des dessins annexés.
La figure 1 montre schématiquement, en section verticale axiale, une première forme de réalisation particulière de l'installation selon l'invention;
La figure 2 montre, à plus grande échelle, un détail de la figure 1, en coupe selon le plan II-II de la figure 1;
La figure 3 est une vue en coupe selon le plan III-III de la figure 2;

Dans ces figures, des mêmes notations de référence désignent des éléments identiques.

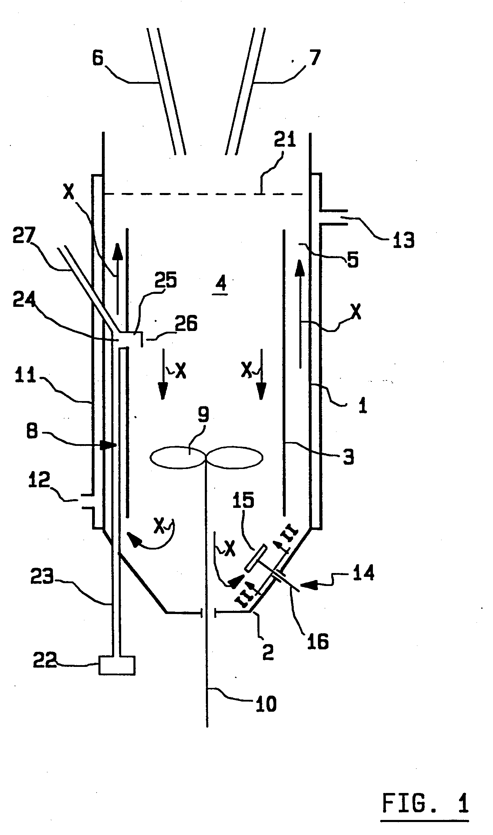

L'installation représentée à la figure 1 est du type de celle décrite dans Kirk-Othmer, Encyclopedia of Chemical Technology, 3rd Edition, Vol. 7, 1979, pages 264-265 et Figure 13. Elle comprend une chambre de cristallisation délimitée par une enceinte cylindrique verticale 1 et un fond tronconique 2. Une cheminée cylindrique verticale 3 est disposée axialement dans la chambre de cristallisation qu'elle divise ainsi en une zone centrale 4 et une zone annulaire 5. Des conduits 6 et 7 servent à l'admission de matières participant à la cristallisation. Une hélice 9 montée sur un arbre vertical 10 est disposée dans le tiers inférieure de la zone centrale 4. L'hélice 9 est du type à écoulement axial et elle a pour fonction, pendant l'exploitation de l'installation, de soumettre un brouet de cristaux à une circulation comprenant une translation descendante dans la zone centrale 4 et une translation ascendante dans la zone annulaire 5. Un exemple d'hélice à écoulement axial est représenté dans Kirk-Othmer, Encyclopedia of Chemical Technology, 3rd Edition, Vol. 15, 1981, page 611, figure 15. L'enceinte 1 peut être entourée d'une enveloppe 11 raccordée à des conduits d'admission 12 et d'évacuation 13 d'un fluide caloporteur. Un dispositif, désigné dans son ensemble par la notation de référence 8 et qui sera décrit par la suite, sert à soutirer par intermittence ou de manière continue, le brouet de cristaux de la chambre de cristallisation.

Conformément à l'invention, la chambre de cristallisation contient, sous la cheminée 3, un organe 14 conçu pour réaliser, pendant l'exploitation de l'installation, un cisaillement mécanique d'un brouet de cristaux. L'organe de cisaillement 14 comprend une roue 15 montée sur un arbre de rotation 16 traversant la paroi tronconique 2 de la chambre de cristallisation.

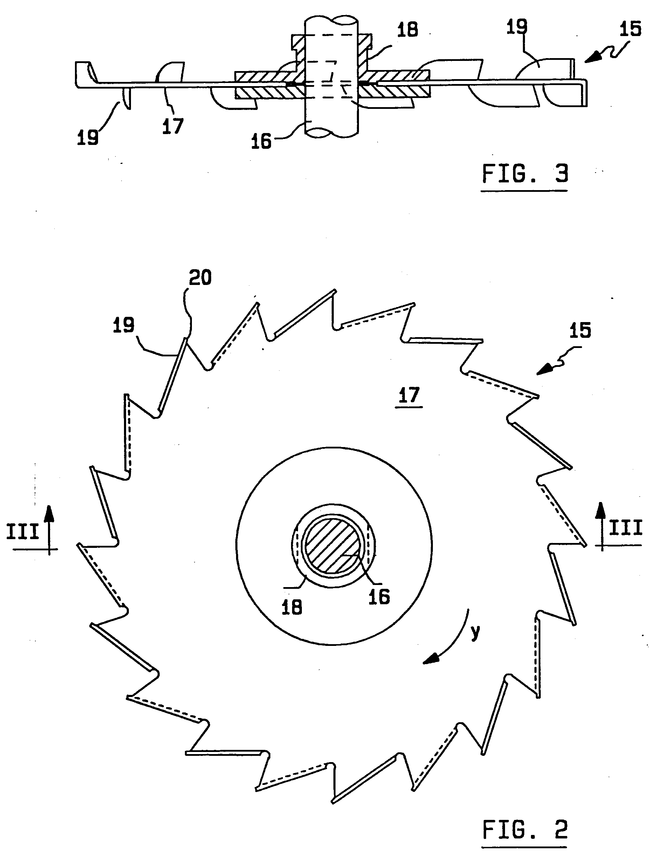

La roue 15, représentée plus en détail aux figures 2 et 3, comprend un disque métallique 17 monté sur une bague 18 destinée à être emmanchée sur l'arbre 16. Il porte à sa périphérie une couronne de dents de cisaillement 19. Celles-ci sont obtenues par pliage et découpe adéquate de la zone périphérique du disque 17, de manière qu'elles présentent une arête frontale de cisaillement 20 dirigée perpendiculairement au disque 17. Les dents de cisaillement 19 sont par ailleurs disposées alternativement et symétriquement de part et d'autre du disque 17. Le disque 17 est destiné à tourner dans le sens de la flèche Y pendant l'exploitation normale de l'installation, de manière que les dents de cisaillement 19 provoquent un cisaillement mécanique d'un brouet de cristaux dans la chambre de cristallisation.

Conformément à l'invention, la position de la roue de cisaillement 15 dans la chambre de cristallisation est telle que la vitesse de circulation du brouet de cristaux comprenne une composante tangentielle au disque 17. Ainsi, sous l'effet de la rotation du disque dans le sens de la flèche Y, le brouet subit un cisaillement mécanique au contact de la roue 15.

Dans l'installation représentée aux figures 1 à 3, l'organe de cisaillement comprend une seule roue de cisaillement 15. En variante il peut comprendre plusieurs roues de cisaillement analogues 15, calées sur l'arbre 16. Selon une autre variante, l'installation peut comprendre plusieurs organes de cisaillement 14, c'est à dire plusieurs roues de cisaillement 15 montées sur des arbres de rotation 16 différents qui sont répartis uniformément à la périphérie du fond tronconique 2 de la chambre de cristallisation.

Conformément à l'invention, le dispositif de soutirage 8 comprend un tube vertical 23 qui s'étend verticalement dans la zone annulaire 5 de la chambre de cristallisation et traverse le fond tronconique de celle-ci. L'extrémité supérieure 24 du tube 23 est pliée à angle droit et débouche dans la zone centrale 4 à travers une ouverture 25 pratiquée à cet effet dans la cheminée 3, approximativement à mi-hauteur de celle-ci. Le passage de l'extrémité 24 du tube à travers l'ouverture 25 est réalisée de manière étanche, pour éviter une communication entre les zones centrale 4 et annulaire 5 par cette ouverture 25. Un déflecteur 26 est par ailleurs fixé à la cheminée 3, dans la zone 4, en regard de l'ouverture 25. Un tube de dégazage 27 traverse l'enceinte 1 et l'enveloppe annulaire 11 et débouche dans l'extrémité supérieure 24 du tube 23. Il est raccordé à une pompe à vide, non représentée, située à l'extérieur de la chambre de cristallisation. L'extrémité inférieure du tube 23 est raccordée à une pompe 22, qui est située à l'extérieur de la chambre de cristallisation et dont la fonction sera explicitée plus loin.

Pendant le fonctionnement de l'installation, la vanne de vidange 29 est fermée et on soutire une fraction du brouet par le dispositif 8. A cet effet, la pompe 22 génère une dépression dans le tube 23 et son extrémité 24, ce qui a pour effet d'y entraîner une fraction du brouet circulant dans la zone 4 au voisinage de l'ouverture 25. Le déflecteur 26 a pour fonction de canaliser le brouet passant de la zone 4 dans le tube 23 et d'éviter la formation de tourbillons à l'entrée de l'ouverture 25. L'importance de la fraction de brouet qui est ainsi soutirée de la chambre de cristallisation par le tube 23 est réglée à volonté par un réglage de la dépression générée par la pompe 22. Pendant le fonctionnement de l'installation, les débits respectifs du carbonate de sodium anhydre dans le conduit 6, de l'eau (ou de la solution aqueuse de carbonate de sodium) dans le conduit 7 et du brouet de cristaux dans le dispositif d'extraction 8 sont réglés de manière à éviter une variation du niveau 21 du brouet et à maintenir la concentration en cristaux de carbonate de sodium monohydraté sensiblement constante dans le brouet.

Le soutirage du brouet via l'ouverture 25 a pour résultat avantageux d'éviter un colmatage de ladite ouverture par des agglomérats de cristaux. Ceux-ci en effet ne participent pas à la circulation du brouet dans les zones 4 et 5 et s'accumulent sur le fond 2 de la chambre de cristallisation. Ils sont périodiquement évacués par une vidange complète de la chambre de cristallisation, après arrêt de l'installation.

L'installation représentée aux figures 1 à 3 convient notamment pour la production de cristaux de carbonate de sodium monohydraté au départ de carbonate de sodium anhydre. Dans cette application de l'installation, la chambre de cristallisation est remplie, sensiblement jusqu'au niveau 21, d'un brouet aqueux de cristaux de carbonate de sodium monohydraté dont la température est maintenue en permanence quelques degrés au-dessous de la température de transition du carbonate de sodium monohydraté en carbonate de sodium anhydre. On introduit du carbonate de sodium anhydre dans la chambre de cristallisation par le conduit 6. Simultanément, on introduit de l'eau (ou une solution aqueuse de carbonate de sodium) dans la chambre de cristallisation, par le conduit 7. On soutire une fraction du brouet par le dispositif 8.

Les débits respectifs du carbonate de sodium anhydre dans le conduit 6, de l'eau (ou de la solution aqueuse de carbonate de sodium) dans le conduit 7 et du brouet de cristaux dans le dispositif de soutirage 8 sont réglés de manière à éviter une variation du niveau 21 du brouet et à maintenir la concentration en cristaux de carbonate de sodium monohydraté sensiblement constante dans le brouet. Sous l'action de la rotation de l'hélice 9, le brouet de cristaux est soumis à une circulation permanente dans la chambre de cristallisation, schématisée par les flèches X et comprenant une translation descendante dans la zone centrale 4 et une translation ascendante dans la zone annulaire 5. Pendant la circulation du brouet dans la chambre de cristallisation, le carbonate de sodium anhydre recristallise à l'état de carbonate de sodium monohydraté. Le cisaillement mécanique provoqué par la roue 15 réalise une désursaturation locale de la solution aqueuse sursaturée de carbonate de sodium monohydraté, provoquant la formation spontanée de germes de cristallisation et, accessoirement, un bris des cristaux du brouet. La formation des germes et le bris des cristaux a pour résultat d'augmenter le nombre de germes de cristallisation et, par voie de conséquence, de diminuer la granulométrie des cristaux recueillis par le dispositif de soutirage 8. Un réglage approprié de la vitesse de rotation de la roue de cisaillement 15, associé à un réglage approprié de la vitesse de circulation du brouet de cristaux dans la chambre de cristallisation, permet de régler à volonté les caractéristiques granulométriques des cristaux de carbonate de sodium monohydraté soutirés par le dispositif 8.

Des particularités et détails concernant le mode opératoire de cette application de l'invention sont accessibles dans le brevet EP-B-073085 (SOLVAY).

L'application qui vient d'être décrite de l'invention convient pour la production de carbonate de sodium anhydre dense (appelé communément soude dense) au départ de carbonate de sodium anhydre léger (appelé communément soude légère) (Te-Pang Hou, Manufacture of Soda, deuxième édition, Hafner Publishing Company, New York, 1969, pages 257 et 261). A cet effet, le carbonate de sodium anhydre mis en oeuvre est du carbonate de sodium léger et les cristaux de carbonate de sodium monohydraté recueillis du brouet sont soumis à un séchage suivi d'une calcination à une température supérieure à la température de transition du carbonate de sodium monohydraté en carbonate de sodium anhydre.

## Revendications

1. Installation pour la cristallisation d'une substance minérale dans un brouet de cristaux, par désursaturation d'une solution sursaturée, l'installation comprenant une chambre de cristallisation (4, 5) et un dispositif (9) conçu pour réaliser une circulation (X) du brouet dans la chambre de cristallisation, caractérisée en ce que la chambre de cristallisation contient un organe (14) de cisaillement mécanique du brouet, comprenant un disque (17) pourvu, à sa périphérie, d'une couronne de dents de cisaillement (19).

2. Installation selon la revendication 1, caractérisée en ce que les dents de cisaillement (19) sont disposées symétriquement de part et d'autre du disque (17).

3. Installation selon la revendication 2, caractérisée en ce que les dents (19) sont dirigées perpendiculairement au disque (17).

4. Installation selon l'une quelconque des revendications 1 à 3, caractérisée en ce que le disque (17) est disposé dans la chambre de cristallisation de manière que la vitesse de la circulation (X) du brouet de cristaux dans la chambre de cristallisation présente une composante tangentielle au disque (17).

5. Installation selon l'une quelconque des revendications 1 à 4, caractérisée en ce que la chambre de cristallisation est délimitée par une enceinte cylindrique verticale (1) et est divisée en une zone centrale (4) et une zone annulaire (5) par une cheminée cylindrique (3) disposée axialement dans l'enceinte (1) et ouverte à ses extrémités supérieure et inférieure, et en ce que ladite circulation (X) du brouet dans la chambre de cristallisation comprend une translation verticale dans la zone centrale (4) et une translation verticale de sens opposé dans la zone annulaire (5).

6. Installation selon la revendication 5, caractérisée en ce que le disque (17) est disposé sous la cheminée (3).

7. Installation selon la revendication 5 ou 6, caractérisée en ce qu'un dispositif (8) de soutirage du brouet comprend un tuyau (23, 24) qui débouche (25) dans une des zones (4, 5) précitées.

8. Installation selon la revendication 7, caractérisée en ce que le tuyau (23, 24) débouche dans la partie médiane de la zone (4, 5).

9. Installation selon la revendication 8, caractérisée en ce que le tuyau (23, 24) débouche dans la moitié supérieure de la partie médiane de la zone (4, 5).

10. Installation selon l'une quelconque des revendications 7 à 9, caractérisée en ce que la zone dans laquelle le tuyau (23, 24) débouche est la zone centrale (4).

11. Installation selon la revendication 10, caractérisée en ce que le tuyau (23, 24) s'étend dans la zone annulaire (5) et débouche dans la zone centrale (4) à travers la cheminée (3).

12. Installation selon la revendication 11, caractérisée en ce que le tuyau (23) s'étend verticalement dans la zone annulaire (5) de la chambre de cristallisation et traverse l'enceinte (2).

13. Installation selon l'une quelconque des revendications 7 à 12, caractérisée en ce que le tuyau (24) est en communication avec un tube de dégazage (27).

14. Installation selon l'une quelconque des revendications 7 à 13, caractérisée en ce que la circulation (X) du brouet dans la chambre de cristallisation comprend une translation descendante dans la zone centrale (4) et une translation ascendante dans la zone annulaire (5).

15. Installation selon la revendication 14, caractérisée en ce le dispositif précité pour réaliser une circulation du brouet dans la chambre de cristallisation comprend une hélice (9) du type à écoulement axial, disposée axialement dans la partie inférieure de la zone centrale (4).

16. Procédé pour la cristallisation d'une substance minérale, selon lequel on met en oeuvre un brouet de cristaux dans une solution sursaturée en la substance à cristalliser, on soumet le brouet à une circulation dans une installation de cristallisation, on cristallise la substance par désursaturation de la solution et on soutire une fraction au moins du brouet hors de l'installation, caractérisé en ce qu'on met en oeuvre une installation de cristallisation conforme à l'une quelconque des revendications 1 à 15.

17. Procédé selon la revendication 16, caractérisé en ce qu'on met en oeuvre un brouet de cristaux de carbonate de sodium monohydraté dans une solution aqueuse saturée de carbonate de sodium monohydraté et on sursature la solution en carbonate de sodium monohydraté en y introduisant du carbonate de sodium anhydre.

## Claims

1. Installation for the crystallisation of an inorganic substance in a crystal slurry, by desupersaturation of a supersaturated solution, the installation comprising a crystallisation chamber (4, 5) and a device (9) designed to bring about circulation (X) of the slurry in the crystallization chamber, characterized in that the crystallization chamber contains a member (14) for the mechanical shearing of the slurry, comprising a disc (17) provided with a ring of shearing teeth (19) on its periphery.

2. Installation according to Claim 1, characterized in that the shearing teeth (19) are arranged symmetrically on either side of the disc (17).

3. Installation according to Claim 2, characterized in that the teeth (19) point at right angles to the disc (17).

4. Installation according to any one of Claim 1 to 3, characterized in that the disc (17) is arranged in the crystallization chamber in such a manner that the speed of circulation (X) of the crystal slurry in the crystallization chamber exhibits a component tangential to the disc (17).

5. Installation according to any one of Claim 1 to 4, characterized in that the crystallization chamber is delimited by a vertical cylindrical enclosure (1) and is divided into a central zone (4) and an annular zone (5) by a cylindrical chimney (3) arranged axially in the enclosure (1) and open at its upper and lower ends, and in that the said circulation (X) of the slurry in the crystallization chamber comprises a vertical translation in the central zone (4) and a vertical translation in the opposite direction in the annular zone (5).

6. Installation according to Claim 5, characterized in that the disc (17) is arranged under the chimney (3).

7. Installation according to Claim 5 or 6, characterized in that a device (8) for withdrawing the slurry comprises a tube (23, 24) which opens (25) into one of the abovementioned zones (4, 5).

8. Installation according to Claim 7, characterized in that the tube (23, 24) opens into the middle part of the zone (4, 5).

9. Installation according to Claim 8, characterized in that the tube (23, 24) opens into the upper half of the middle part of the zone (4, 5).

10. Installation according to any one of Claims 7 to 9, characterized in that the zone into which the tube (23, 24) opens is the central zone (4).

11. Installation according to Claim 10, characterized in that the tube (23, 24) runs in the annular zone (5) and opens into the central zone (4) across the chimney (3).

12. Installation according to Claim 11, characterized in that the tube (23) runs vertically in the annular zone (5) of the crystallization chamber and passes through the enclosure (2).

13. Installation according to any one of Claims 7 to 12, characterized in that the tube (24) communicates with a degassing tube (27).

14. Installation according to any one of Claims 7 to 13, characterized in that the circulation (X) of the slurry in the crystallization chamber comprises a descending translation in the central zone (4) and an ascending translation in the annular zone (5).

15. Installation according to Claim 14, characterised in that the abovementioned device for bringing about circulation of the slurry in the crystallisation chamber comprises a helix (9) of the axial flow type, arranged axially in the lower part of the central zone (4).

16. Process for the crystallization of an inorganic substance, according to which a slurry of crystals in a solution supersaturated with the substance to be crystallised is employed, the slurry is subjected to circulation in a crystallisation installation, the substance is crystallised by desupersaturation of the solution and at least a fraction of the slurry is withdrawn from the installation, characterized in that a crystallisation installation according to any one of Claims 1 to 15 is employed.

17. Process according to Claim 16, characterised in that a slurry of sodium carbonate monohydrate crystals in a saturated aqueous solution of sodium carbonate monohydrate is employed and the solution is supersaturated with sodium carbonate monohydrate by introducing anhydrous sodium carbonate into it.

## Patentansprüche

1. Vorrichtung zur Kristallisation einer mineralischen Substanz in einer Kristallbrühe, durch Entübersättigung einer übersättigten Lösung, wobei die Vorrichtung eine Kristallisationskammer (4, 5) und eine zum Erzielen einer Zirkulation (X) der Brühe in der Kristallisationskammer vorgesehene Einrichtung (9) umfaßt, dadurch gekennzeichnet, daß die Kristallisationskammer ein Organ (14) zur mechanischen Scherung der Brühe enthält, umfassend eine an ihrem Rand mit einer Krone von Scherzähnen (19) versehene Scheibe.

2. Vorrichtung nach Anspruch 1, dadurch gekennzeichnet, daß die Scherzähne (19) symmetrisch auf beiden Seiten der Scheibe angeordnet sind.

3. Vorrichtung nach Anspruch 2, dadurch gekennzeichnet, daß die Zähne (19) senkrecht zur Scheibe (17) ausgerichtet sind.

4. Vorrichtung nach einem beliebigen der Ansprüche 1 bis 3, dadurch gekennzeichnet, daß die Scheibe (17) so in der Kristallisationskammer angeordnet ist, daß die Geschwindigkeit der Zirkulation (X) der Kristallbrühe in der Kristallisationskammer eine zur Scheibe (17) tangentiale Komponente aufweist.

5. Vorrichtung nach einem beliebigen der Ansprüche 1 bis 4, dadurch gekennzeichnet, daß die Kristallisationskammer von einem vertikalen zylindrischen Gehäuse (1) begrenzt wird und durch einen axial im Gehäuse (1) angeordneten und an seinem oberen und unteren Ende offenen zylindrischen Schlot (3) in eine Mittenzone (4) und eine Ringzone (5) unterteilt wird, und daß die besagte Zirkulation (X) der Brühe in der Kristallisationskammer eine vertikale Translation in der Mittenzone (4) und eine vertikale Translation mit entgegengesetzter Richtung in der Ringzone (5) umfaßt.

6. Vorrichtung nach Anspruch 5, dadurch gekennzeichnet, daß die Scheibe unter dem Schlot (3) angeordnet ist.

7. Vorrichtung nach Anspruch 5 oder 6, dadurch gekennzeichnet, daß eine Einrichtung (8) zum Abziehen der Brühe ein Rohr (23, 24) umfaßt, das in eine der vorgenannten Zonen (4, 5) mündet (25).

8. Vorrichtung nach Anspruch 7, dadurch gekennzeichnet, daß das Rohr (23, 24) in den Mittelteil der Zone (4, 5) mündet.

9. Vorrichtung nach Anspruch 8, dadurch gekennzeichnet, daß das Rohr (23, 24) in die obere Hälfte des Mittelteils der Zone (4, 5) mündet.

10. Vorrichtung nach einem beliebigen der Ansprüche 7 bis 9, dadurch gekennzeichnet, daß die Zone, in welche das Rohr (23, 24) mündet, die Mittenzone (4) ist.

11. Vorrichtung nach Anspruch 10, dadurch gekennzeichnet, daß das Rohr (23, 24) in der Ringzone (5) verläuft und durch den Schlot (3) hindurch in die Mittenzone (4) mündet.

12. Vorrichtung nach Anspruch 11, dadurch gekennzeichnet, daß das Rohr (23, 24) vertikal in der Ringzone (5) der Kristallisationskammer verläuft und das Gehäuse (2) durchquert.

13. Vorrichtung nach einem beliebigen der Ansprüche 7 bis 12, dadurch gekennzeichnet, daß das Rohr (24) mit einem Entgasungsrohr (27) verbunden ist.

14. Vorrichtung nach einem beliebigen der Ansprüche 7 bis 13, dadurch gekennzeichnet, daß die Zirkulation (X) der Brühe in der Kristallisationskammer eine absteigende Translation in der Mittenzone (4) und eine aufsteigende Translation in der Ringzone (5) umfaßt.

15. Vorrichtung nach Anspruch 14, dadurch gekennzeichnet, daß die vorgenannte Einrichtung zum Erreichen einer Zirkulation (X) der Brühe in der Kristallisationskammer eine Schraube (9) von der Art mit axialer Strömung umfaßt, die axial im unteren Teil der Mittenzone (4) angeordnet ist.

16. Verfahren zur Kristallisation einer mineralischen Substanz, gemäß welchem man eine Kristallbrühe in einer übersättigten Lösung der zu kristallisierenden Substanz verwendet, man die Brühe in einer Kristallisationsvorrichtung einer Zirkulation unterwirft, man die Substanz durch Entübersättigung der Lösung kristallisiert und man mindestens einen Teil der Brühe aus der Vorrichtung heraus abzieht, dadurch gekennzeichnet, daß man eine Kristallisationsvorrichtung nach einem beliebigen der Ansprüche 1 bis 15 verwendet.

17. Verfahren nach Anspruch 16, dadurch gekennzeichnet, daß man eine Natriumcarbonatmonohydrat-Kristallbrühe in einer mit Natriumcarbonatmonohydrat gesättigten wässrigen Lösung verwendet, und man die Natriumcarbonatmonohydratlösung übersättigt, indem man ihr wasserfreies Natriumcarbonat zuführt.
